# EUROPEAN PATENT APPLICATION

(11) **EP 4 618 158 A1**
(43) Date of publication of application: **17.09.2025**
(21) Application number: 24162763.7
(22) Date of filing: 11.03.2024
(51) Int. Cl.: H01L 29/423, H01L 29/66, H01L 29/76, B82Y 10/00

(54) **A QUANTUM ELECTRONIC DEVICE WITH A CHARGE DETECTOR FOR DETERMINING A PROPERTY OF A QUBIT, AND A METHOD FOR DETERMINING SAID PROPERTY**

(71) Applicant: Nederlandse Organisatie voor toegepast-natuurwetenschappelijk Onderzoek TNO, 2595 DA 's-Gravenhage (NL)
(72) Inventor: AMITONOV, Sergey Vladimirovich, 2595 DA 's-Gravenhage (NL); SAMKHARADZE, Nodar, 2595 DA 's-Gravenhage (NL)
(74) Representative: V.O.

(57) **Abstract**

The invention pertains to a quantum electronic device with at least one charge detector (3) configured to determine a property of a semiconductor quantum dot (5), and a method for determine a property of a semiconductor quantum dot (5) controlled by a plunger gate (13). The charge detector (3) is arranged at or in vicinity of the semiconductor quantum dot (5). The charge detector is a single electron box, SEB, detector including a conductive island (10) separated from an electrode (9) by means of a quantum tunnel barrier (11), wherein the quantum tunnel barrier is configured to facilitate electron tunneling indicative of quantum state variations. The tunneling is used to infer a state of a qubit associated with the quantum dot, wherein the electrode is connected to a circuitry configured to enable readout of the state of the qubit associated with the quantum dot.

## Description

### FIELD OF THE INVENTION

The invention relates to a quantum electronic device comprising at least one charge detector configured to determine a property of a semiconductor quantum dot, the charge detector being arranged at or in vicinity of the semiconductor quantum dot. Furthermore, the invention relates to a method for determining a property of a qubit associated with a semiconductor quantum dot in a quantum electronic device. The invention also relates to a quantum processing system comprising a quantum electronic device. Additionally, the invention relates to a charge detector for use in a quantum electronic device.

### BACKGROUND TO THE INVENTION

The field of quantum computing has witnessed significant advancements in recent years, driven by the quest for computational capabilities far beyond what is achievable with classical computing systems. A critical component of quantum computing involves the manipulation and readout of quantum bits, or qubits, which are the fundamental units of information in quantum systems. Semiconductor quantum dots have emerged as a promising platform for realizing qubits, owing to their potential for scalability and integration into existing semiconductor technologies. However, the precise control and measurement of the quantum state of these qubits present significant technical challenges, which are exacerbated as the scale and complexity of quantum computing systems increase.

One of the challenges in the development of scalable quantum computing systems is the efficient and accurate readout of qubit states. Traditional methods, such as the use of radio-frequency single electron transistors (RF-SETs), have been employed for single-shot spin state readout via spin-to-charge conversion. While RF-SETs offer decent sensitivity and have been instrumental in the progress of small-scale quantum computing arrays, they are not without limitations. The necessity for each RF-SET to be in close proximity to a qubit requires significant space around the quantum dot arrays, which can compromise the connectivity between qubits and increase circuit complexity. This spatial requirement poses a substantial barrier to the scalability of quantum computing architectures, as the integration density of qubits is a critical factor for achieving the computational power envisioned for quantum processors.

Furthermore, the operational complexity and resource intensity associated with RF-SETs, including the need for multiple terminals and the associated wiring and control infrastructure, add further constraints to the design and scalability of quantum computing systems. These challenges are compounded in larger arrays, where the management of interference and cross-talk between closely packed detectors may become problematic.

For example, in solid-state spin-based semiconductor qubits a charge detector is required to perform single-shot spin state readout via spin-to-charge conversion. Usually, radio-frequency single electron transistor is used for the single-shot readout in small-scale modern qubit arrays. Providing good sensitivity, each single electron transistor must be in the vicinity of a qubit, and requires three terminals, and thus significant space around qubit arrays. This compromise qubits connectivity, circuit complexity, hence scalability and performance of a quantum processor.

Mostly RF single electron transistor is used as detector for the spin qubits. It works well for the small circuits of qubit arrays where space is not a limiting factor. No spin qubit arrays with N>8 has been demonstrated.

Alternative approaches, such as gate reflectometry, have been explored to address some of these challenges. This technique involves the direct connection of an LC circuit to the plunger gate of a quantum dot, allowing for the detection of tunneling events around the quantum dot. However, despite its advantages in terms of reduced spatial requirements compared to RF-SETs, gate reflectometry has not demonstrated sufficient performance for reliable single-shot spin qubit readout, particularly in terms of sensitivity and speed.

The limitations of current technologies underscore the need for innovative solutions that can overcome the challenges of qubit state readout in semiconductor quantum dots. An ideal solution would offer high sensitivity and accuracy comparable to or exceeding that of RF-SETs, while also addressing the issues of scalability, circuit complexity, and spatial constraints inherent in existing approaches. The development of such a solution is desired for the realization of practical, large-scale quantum computing systems, opening new ways for quantum information processing and technology.

### SUMMARY OF THE INVENTION

It is an object of the invention to provide for a method and a system that obviates at least one of the above mentioned drawbacks.

Additionally or alternatively, it is an object of the invention to provide for a quantum electronic device with an improved charge detector for determining a property of a semiconductor quantum dot.

Additionally or alternatively, it is an object of the invention to enhance the integration density of qubits within quantum computing systems without compromising the accuracy and efficiency of qubit state readout.

Additionally or alternatively, it is an object of the invention to reduce the operational complexity and/or resource requirements for qubit state detection, facilitating the scalability and practical implementation of quantum computing architectures.

Thereto, the invention provides for a quantum electronic device comprising at least one charge detector configured to determine a property of a semiconductor quantum dot, the charge detector being arranged at or in vicinity of the semiconductor quantum dot, wherein the charge detector is a single electron box, SEB, detector including a conductive island separated from an electrode by means of a quantum tunnel barrier, wherein the quantum tunnel barrier is configured to facilitate electron tunneling indicative of quantum state variations, wherein the tunneling is used to infer a state of a qubit associated with the quantum dot, wherein the electrode is connected to a circuitry configured to enable readout of the state of the qubit associated with the quantum dot.

Single electron box requires only one tunnel junction and operates at the different principles compared to the RF single electron transistor. Single electron box requires electrons to tunnel between the island and the electrode. In the gate reflectometry technique, gate is coupled only capacitively coupled to quantum dots.

The single electron box (SEB) detector is positioned at or near a semiconductor quantum dot to discern a property thereof. The SEB detector comprises a conductive island separated from an electrode by a quantum tunnel barrier, designed to enable electron tunneling reflective of quantum state changes. This tunneling mechanism facilitates the inference of a qubit state associated with the quantum dot, with the electrode being linked to circuitry for the qubit state's readout. A precise and localized state detection of qubits can be provided, enhancing the fidelity and speed of quantum computing operations. A coupling of the SEB detector to the quantum dot can be achieved, allowing for immediate and sensitive detection of quantum state variations through electron tunneling.

Comparatively, systems that utilize Single Electron Transistors (SET) for qubit state detection face several challenges that the SEB-based system overcomes.

The spatial efficiency can be significantly increased. SETs typically require three terminals (source, drain, and gate) for operation, which necessitates more space around each qubit for the placement of these terminals. The SEB's compact design, requiring only a single tunnel junction, allows for a denser packing of qubits, facilitating scalability and integration within quantum processors without compromising the connectivity or the complexity of the quantum circuit.

Furthermore, the scalability can be enhanced. Due to the simpler architecture of the SEB, with its single-electrode configuration, the complexity of the quantum circuitry can be reduced. This simplicity is beneficial for scaling up quantum processors to include more qubits, a critical factor for achieving the computational power required for practical quantum computing applications.

Moreover, a high sensitivity can be obtained with a compact form factor. Despite its compact size, the SEB maintains a sensitivity comparable to that of the SET for detecting quantum state variations. This high sensitivity is achieved through the optimized coupling of the SEB to the quantum dot and the efficient detection of electron tunneling events, which are indicative of the qubit's state. This means that the SEB can achieve the same level of performance as the SET in terms of state detection fidelity but with a significantly reduced spatial footprint and circuit complexity.

Fidelity refers to the accuracy with which quantum states are read and manipulated, a crucial factor for the reliability of quantum computations and the minimization of errors. Speed, on the other hand, pertains to the rapidity of performing quantum operations, including the readout process, which is essential for practical quantum computing applications. The SEB detector's proximity to the quantum dot enables the detection mechanism to be highly sensitive to the quantum state variations of the qubit, primarily through the tunneling of electrons. Electron tunneling is a quantum mechanical phenomenon that allows electrons to pass through a barrier that would be insurmountable in classical mechanics. In the context of the SEB detector, this tunneling is indicative of the qubit's quantum state, providing a direct and immediate means to assess the qubit's condition.

The direct coupling of the SEB detector to the quantum dot facilitates an immediate interaction between the detection mechanism and the qubit's quantum states. This direct interaction ensures that any change in the quantum state, such as a spin-to-charge conversion event, is promptly detected by the SEB, thereby minimizing the latency in readout and increasing the speed of quantum operations. This immediacy is important for quantum algorithms that require rapid state readouts, enabling faster processing times and increasing the throughput of quantum computations.

Optionally, the SEB detector is connected to a radio-frequency, RF, circuitry.

This configuration enhances the device's capability to perform highfrequency readouts, leveraging the fast response times and high sensitivity of RF systems to detect qubit state changes. An improved readout speed and sensitivity can be obtained, achieved by utilizing the RF field's ability to quickly and accurately capture the tunneling events indicative of quantum state changes.

The RF circuitry is adept at handling signals at high frequencies, which can be important for quantum computing applications where the speed of qubit state readout can significantly impact overall computational performance. The SEB detector, when coupled with RF circuitry, benefits from this capability, enabling it to perform readouts at a much higher frequency compared to traditional methods. This high-speed readout allows for quicker data acquisition and processing, an important factor in real-time quantum computing operations and in systems requiring rapid feedback loops for error correction.

The nature of RF circuitry, which is designed to quickly respond to changes in signal characteristics, complements the SEB detector's sensitivity to electron tunneling events. This rapid response is important for detecting transient events that characterize quantum state changes, ensuring that every alteration in the qubit's state is accurately captured and analyzed without delay.

RF systems are inherently sensitive to small changes in signal parameters, such as amplitude, phase, and frequency. When integrated with the SEB detector, this sensitivity is harnessed to detect the subtle electron tunneling events indicative of qubit state variations. This sensitivity is particularly important in quantum computing, where the accurate detection of quantum states, often represented by very slight changes in the electrostatic environment, is important for the correct operation of quantum algorithms.

The combination of the SEB detector with RF circuitry enhances the device's capability to detect qubit state changes with improved speed and sensitivity. The RF circuitry, tailored to the SEB detector's operational characteristics, optimizes the detection of electron tunneling events by matching the system's impedance and tuning into the specific frequencies at which these events occur. This optimization allows for a more precise readout of the qubit state changes, minimizing noise and improving the signal-to-noise ratio.

By leveraging the RF field, the system can quickly adapt to changes in the quantum state, allowing for near-instantaneous readout of the qubit states. This rapid readout can be important for dynamic quantum computing operations where the state of qubits may change frequently and unpredictably.

Optionally, the RF circuitry includes an LC resonating circuit matched to the impedance of the SEB detector for qubit state detection.

This arrangement facilitates a resonant condition that maximizes the energy transfer between the SEB detector and the LC circuit, thereby enhancing the sensitivity and specificity of qubit state readouts. Impedance matching can be performed, which optimizes the signal-to-noise ratio for clearer and more accurate detection of quantum state variations. The matched impedance condition creates an efficient energy exchange pathway between the SEB detector and the LC circuit. This optimized energy transfer is important for detecting minute changes in the quantum state of qubits, which are often represented by subtle variations in the electrical properties of the system. By maximizing the resonant energy transfer, the device can more readily detect these small changes, leading to higher sensitivity in qubit state readouts.

The specificity of qubit state detection is enhanced through the resonant condition because it allows the system to be highly responsive to the specific frequencies associated with different quantum states. This responsiveness means that the system can differentiate between various states with greater accuracy, reducing the likelihood of erroneous readouts and improving the reliability of quantum computations.

Impedance matching plays an important role in optimizing the signal-to-noise ratio of the system. A high SNR can be important for quantum computing applications, where the accuracy of qubit state detection directly impacts the overall performance of the quantum processor. By matching the impedance of the SEB detector to the LC circuit, the device minimizes energy losses and reduces the impact of external noise on the signal. This optimization ensures that the signals corresponding to quantum state variations are more pronounced and easier to distinguish from background noise, leading to clearer and more accurate readouts.

The impedance of the SEB detector and the LC resonating circuit can be perfectly matched. This process may involve precise calculations and adjustments to the components of the LC circuit (i.e., the inductor (L) and capacitor (C)) to achieve the desired resonant frequency that aligns with the operational characteristics of the SEB detector. By doing so, the device capitalizes on the principles of resonance to optimize energy transfer, thereby enhancing the sensitivity, specificity, and signal clarity of qubit state readouts.

Optionally, the RF circuitry is configured to facilitate dispersive readout based on RF reflectometry, wherein the RF circuitry is configured to detect spin-to-charge conversion events by monitoring changes in reflected signal parameters.

Spin-to-charge conversion events can be detected by monitoring changes in reflected signal parameters. A non-invasive and highly sensitive way for reading quantum states is obtained that is achieved by analyzing the modifications in RF signals reflected off the SEB detector. This enables real-time monitoring of quantum state changes with minimal disturbance to the system.

The RF circuitry allows to discern subtle changes in the quantum state of a semiconductor quantum dot through spin-to-charge conversion events. These events are identified by observing alterations in the parameters of RF signals reflected back from the single electron box (SEB) detector.

Dispersive readout via RF reflectometry operates by emitting an RF signal towards the SEB detector and analyzing the reflected signal's characteristics. Changes in the quantum dot's charge state, resulting from spin-to-charge conversion, alter the electrostatic environment around the SEB detector. These alterations, in turn, affect the impedance of the SEB detector, which is closely coupled to the quantum dot. The impedance changes are reflected in the RF signal's amplitude, phase, or frequency that bounces back from the detector. By monitoring these changes, the device can infer the quantum state of the qubit with high precision.

Traditional methods of qubit readout might require direct electrical interaction with the quantum dot, potentially perturbing its quantum state and introducing measurement errors. In contrast, RF reflectometry allows for the quantum state to be deduced from afar, minimizing any direct interaction that could destabilize the qubit. Moreover, this method boasts high sensitivity, a result of its ability to detect small changes in the reflected RF signal's parameters. This sensitivity is important for identifying the subtle spin-to-charge conversion events that signify quantum state transitions. The high sensitivity ensures that even weak signals, indicative of minor quantum state variations, can be accurately detected and analyzed.

The RF circuitry's rapid response to impedance changes enables the immediate (e.g. real-time) detection of quantum state alterations, facilitating dynamic readouts without the need for lengthy measurement periods.

Optionally, the device comprises a plunger gate for controlling one or more characteristics of the quantum dot.

A plunger gate can be used to control the electrostatic potential of a quantum dot. By applying a voltage to the plunger gate, one can adjust the energy levels within the quantum dot. This control can be important for the initialization, manipulation, and readout of qubits that are based on the quantum states of electrons in the quantum dot.

The plunger gate can also be used to adjust the number of electrons within a quantum dot. By fine-tuning the voltage, electrons can be added to or removed from the quantum dot, which can be important for defining qubit states or creating the desired conditions for quantum computation.

For quantum dots acting as qubits, operations such as qubit initialization, manipulation (gate operations), and measurement are influenced by the electrostatic environment controlled by the plunger gate. The ability to precisely control this environment allows for the coherent manipulation of qubit states, which is important for quantum computing.

In systems where multiple quantum dots host qubits, plunger gates can be used to adjust the coupling between these qubits.

Furthermore, in quantum dot systems, the plunger gate can improve the fidelity of qubit state readout. By adjusting the quantum dot's potential, the plunger gate can facilitate a more distinct separation between different charge states or spin states during the readout process, leading to higher accuracy in determining the qubit's state.

The provision of a plunger gate enables an improved control over quantum state preparation and manipulation, contributing to higher fidelity quantum operations. By adjusting the voltage applied to the plunger gate, the potential well of the quantum dot can be finely tuned. This allows for the exact positioning of the electron (or holes) within the quantum dot, effectively controlling the qubit's quantum state. This level of control is indispensable for initializing the qubit into a known state, manipulating it to perform quantum operations, and accurately reading out its final state.

Before any quantum computation can occur, qubits are initialized into a known state. The plunger gate enables this by adjusting the quantum dot's potential to capture or release electrons, thus setting the qubit to a starting position. This precision ensures that the quantum operations begin from a defined and controlled state, increasing the reliability of the computational outcomes.

By modulating the potential landscape of the quantum dot, the plunger gate facilitates the coherent manipulation of the qubit's state. This manipulation is achieved through the precise control over the quantum dot's energy levels, enabling the execution of quantum logic operations that form the basis of quantum algorithms.

Optionally, the SEB detector is integrated in a structure of the plunger gate.

This integration allows for a compact and efficient design, reducing the spatial footprint and improving the detector's sensitivity by positioning it closer to the quantum dot. Advantageously, the seamless incorporation of the detection and control elements, enables simultaneous qubit manipulation and readout with enhanced precision and/or reduced latency.

Traditional quantum computing setups often require separate components for qubit control and state readout, leading to increased complexity and size. By embedding the SEB detector directly within the plunger gate, this design efficiently utilizes space, allowing for a more compact device layout. The reduced spatial requirement not only facilitates easier scaling of the quantum processor architecture but also enhances the feasibility of implementing more complex quantum systems within limited physical dimensions.

Positioning the SEB detector in close proximity to the semiconductor quantum dot, by virtue of its integration into the plunger gate, significantly improves the detector's sensitivity to quantum state changes. The closeness ensures that any alterations in the quantum dot's state-such as those arising from spin-to-charge conversion events-are promptly and accurately captured by the SEB detector. This immediate detection is critical for high-fidelity readouts, as it minimizes the loss of quantum information that might occur with longer detection pathways or delays caused by spatial separations.

The seamless incorporation of the detection (SEB detector) and control (plunger gate) elements within a single structure enables the simultaneous manipulation and readout of qubit states. This dual functionality provides for dynamic quantum computing operations, where the ability to quickly adjust qubit states and immediately read those states can significantly enhance computational efficiency and speed. This simultaneous operation reduces latency between qubit manipulation and state detection, an important factor in executing complex quantum algorithms and processes with higher throughput.

The integrated design inherently leads to reduced latency in the system. In quantum computing, the speed at which qubit states can be manipulated and read is a critical performance metric. By integrating the SEB detector with the plunger gate, the time lag between initiating a change in the quantum dot and detecting that change is minimized. This reduction in latency not only improves the overall speed of quantum computation but also enhances the coherence time of qubits by allowing faster feedback and correction mechanisms, which can be important for quantum error correction techniques.

In some examples, the fabrication process comprises adding a tunnel barrier layer during the creation of the SEB-equipped plunger gate, enabling the plunger gate to serve a dual purpose as both a charge sensor and a carrier induction mechanism.

Advantageously, the compactness and efficiency of the quantum electronic device can be improved. This can directly contribute to the scalability and integration capabilities of quantum processing systems. By reducing the spatial and material requirements of traditional quantum detection mechanisms, the SEB detectors described herein enable more densely packed quantum computing arrays.

Optionally, the SEB detector is integrated as a termination of the plunger gate.

This arrangement maximizes the interaction between the plunger gate and the SEB detector, facilitating immediate and highly sensitive detection of electron tunneling events. A minimized physical separation between the control and detection components can be obtained, leading to quicker and more accurate readouts by reducing the delay between qubit state changes and detection.

The SEB detector, being an integral part of the plunger gate, is in the immediate electrostatic environment influenced by the quantum dot. Any change in the quantum state that affects the electrostatic conditions around the quantum dot directly influences the SEB detector. This direct influence enables the SEB detector to respond to changes with minimal latency, ensuring that the readouts of the qubit states are both rapid and highly accurate.

The physical integration of the SEB detector with the plunger gate minimizes the spatial separation between the control and detection mechanisms within the quantum electronic device. This proximity can be important for reducing the delay traditionally observed between the initiation of a qubit state change and its detection. In conventional setups, where the detector and control elements are separate, the time for an electrostatic change to propagate from the quantum dot to the detector can introduce delays, however minimal, which can affect the precision of the readout. Advantageously, a more synchronized operation between qubit state manipulation and detection can be obtained. The direct and efficient coupling between the plunger gate and the SEB detector facilitates a real-time response to quantum state changes. This means that as soon as a qubit's state is altered via the plunger gate, the SEB detector is instantaneously aware of this change, allowing for an immediate readout. This capability can be of significant importance in quantum computing, where the speed and accuracy of qubit state determination are important for complex computations and error correction algorithms.

Optionally, the plunger gate and the SEB detector are arranged such that adjustments to a plunger gate potential influence the electron tunneling through the quantum tunnel barrier.

Adjustments to the plunger gate potential can directly influence electron tunneling through the quantum tunnel barrier. This direct coupling between the plunger gate potential and the tunneling process enables fine-tuned control over the quantum dot's electrostatic environment, enhancing the precision of qubit state manipulation and detection. The synchronized operation of the plunger gate and the SEB detector, allows for more accurate and efficient quantum computing operations.

The direct coupling grants the device an exceptional level of control over the quantum dot's electrostatic environment. The ability to precisely adjust the plunger gate potential allows for fine-tuned manipulation of the quantum dot's electrostatic environment. This precision can be important for accurately initializing, manipulating, and reading the state of qubits, directly impacting the fidelity of quantum computing operations. The SEB detector, by being in direct communication with the changes induced by the plunger gate, can detect even small variations in electron tunneling events. This sensitivity is important for identifying specific quantum state changes, enabling high-precision qubit state detection.

Optionally, the circuitry is connected (directly) to the plunger gate.

The quantum device's operational efficiency and the accuracy of qubit state readouts can be improved. By facilitating simultaneous manipulation of the quantum dot and detection of qubit states, the device circumvents the latency typically associated with sequential operations. This immediacy between action (plunger gate adjustment) and reaction (qubit state readout) is important for quantum computing, where the fidelity of operations and the speed of computation are important. Moreover, this configuration allows for real-time adjustments to be made based on immediate feedback from the readout process. Such dynamic responsiveness is important in quantum computing, enabling adaptive control strategies that can significantly improve qubit coherence times and error rates.

Optionally, the SEB detector is distinctly positioned apart from, yet in immediate vicinity to, the plunger gate structure.

This arrangement allows for effective electron tunneling detection while maintaining the structural integrity and functional separation of the control and detection elements. The positioning can ensure that the SEB detector is close enough to the quantum dot to accurately detect the subtle changes in the electrostatic environment caused by spin-to-charge conversion, which directly influences the state of a qubit. The spatial arrangement preserves the structural integrity and functional separation between the control (plunger gate) and detection (SEB detector) elements of the device. In some examples, keeping the SEB detector and the plunger gate structurally distinct may reduce electronic crosstalk and magnetic interference between control signals and detection signals. This separation may ensure that the manipulation of qubit states via the plunger gate does not inadvertently affect the detection sensitivity or specificity of the SEB detector. By maintaining functional separation, the device can simultaneously control the quantum dot's characteristics (such as energy levels and tunneling rates) while independently monitoring the qubit's state.

Optionally, the SEB detector is configured to detect charge states associated with spin-based semiconductor qubits through spin-to-charge conversion.

This configuration leverages the SEB detector's sensitivity to electrostatic changes, enabling the precise identification of qubit states based on their charge characteristics. The detector can discern subtle variations in charge states, facilitating accurate and reliable readouts essential for advanced quantum computing operations.

The SEB detector, as integrated into the quantum electronic device, is specifically designed to detect charge states resulting from spin-based semiconductor qubits through a process known as spin-to-charge conversion. This innovative configuration capitalizes on the intrinsic sensitivity of the SEB detector to changes in the electrostatic environment. Such sensitivity is important for the precise identification of qubit states, which are fundamentally associated with their charge characteristics.

Spin-to-charge conversion allows for the translation of quantum information encoded in the spin state of an electron into an easily detectable electrical signal. The SEB detector's role in this process is to identify the resultant charge state changes, which serve as a proxy for the underlying quantum spin states. This capability is rooted in the SEB detector's operational principle, where its conductive island, isolated from an electrode by a quantum tunnel barrier, facilitates electron tunneling that is highly sensitive to the surrounding electrostatic conditions.

A high precision can be achieved through the detector's fine-tuned responsiveness to electrostatic changes in its vicinity, enabling it to capture the detailed differences in charge associated with different spin states of the qubits. Moreover, the SEB detector's adeptness at detecting charge states through spin-to-charge conversion enhances the overall reliability of quantum computing operations. By providing a direct and precise method for reading out qubit states, the SEB detector significantly reduces the error rates associated with quantum state measurement.

Optionally, changes in the parameters of a reflected signal from the RF LC circuit indicate variations in the electric field around the conductive island of the SEB detector, corresponding to spin-to-charge conversion events during qubit readout.

This mechanism provides a sensitive and specific method for detecting quantum state changes, with the technical advantage stemming from the direct correlation between reflected signal parameters and the electrostatic environment. This correlation enables precise monitoring of qubit state transitions, enhancing the device's readout accuracy.

When electrons tunnel through the barrier, indicative of quantum state variations, they cause detectable changes in the electrostatic environment surrounding the conductive island. The device's RF LC circuit is configured to be highly responsive to these electrostatic changes. Variations in the electric field around the SEB detector's conductive island alter the parameters of the RF signal reflected off the circuit. These alterations in the reflected RF signal parameters, such as amplitude, phase, or frequency, directly correspond to spin-to-charge conversion events occurring during the qubit readout process. Spin-to-charge conversion is a phenomenon where the quantum spin state of an electron in the quantum dot is converted into a detectable charge state, enabling the determination of the qubit's state.

By establishing a direct correlation between the reflected RF signal parameters and the electrostatic environment changes, the device can precisely monitor and interpret variations indicative of qubit state transitions. This correlation is achieved through careful design and calibration of the RF LC circuit to match the impedance and operating conditions of the SEB detector, ensuring that the system is highly sensitive to the minute electrostatic changes that signal quantum state alterations.

By correlating specific changes in the reflected RF signal parameters with certain quantum state transitions, the device can accurately distinguish between different qubit states, reducing the likelihood of readout errors.

The use of RF reflectometry for detecting state changes is inherently less invasive than direct measurement techniques, minimizing the disturbance to the quantum system and preserving qubit coherence.

The instantaneous nature of RF signal reflection enables real-time monitoring of qubit states, important for dynamic quantum computing operations and error correction protocols.

Optionally, the SEB detector includes a single quantum tunnel barrier.

By employing a single quantum tunnel barrier, the SEB detector's design is markedly simplified. This simplification extends beyond just the physical layout to encompass the operational dynamics of the device. A singular tunnel barrier reduces the complexity inherent in managing multiple tunneling pathways, which can complicate the control and readout mechanisms due to the variability in electron tunneling behavior across different barriers. With only one pathway for electrons to tunnel through, the device can be tuned and optimized more effectively, ensuring that the operational parameters are finely adjusted to the characteristics of that specific tunneling pathway.

Focusing on a single, optimized tunneling pathway improves the SEB detector's performance by ensuring that the electron tunneling events are highly efficient and reliable. The optimization of the tunnel barrier, considering its thickness, material properties, and the applied voltage, can be tailored to maximize the probability of tunneling events that are indicative of specific quantum states. This precision tuning is important for achieving high-fidelity qubit state detection and readout, as it enhances the sensitivity of the detector to the subtle changes associated with different quantum states.

The efficiency and reliability of electron tunneling events are important for accurate qubit state detection. By minimizing the variables and potential sources of error associated with multiple tunneling pathways, the single quantum tunnel barrier design ensures a consistent and predictable tunneling behavior. This consistency is important for quantum computing, where the accuracy of qubit state readout can directly impact the computational performance and error rates of the quantum processor.

The SEB simplifies the tunnel barrier configuration by using only a single quantum tunnel barrier. This design choice differentiates it from the SET and has implications for the device's functionality and applications. While the SET uses two tunnel barriers to control electron flow between source and drain electrodes, the SEB's single tunnel barrier focuses on the detection of charge states through the modulation of the tunneling process itself, rather than controlling current flow.

The single barrier in the SEB detector simplifies the device structure and operation compared to the SET. This simplification can lead to advantages in terms of device spatial efficiency, fabrication, scalability, and integration with other quantum computing components, as detailed earlier.

Advantageously, the device according to the disclosure does not employ a SET. A SET, which operates based on the Coulomb blockade effect, typically includes a small conductive island connected to source and drain electrodes through two tunnel junctions. The presence of two tunnel barriers allow electrons to tunnel onto and off the island, but only under specific conditions related to the voltage applied to a gate electrode that influences the island's electrostatic potential. The dual-tunnel barrier configuration of the SET enables it to function as a transistor, where the current flow between the source and drain is modulated by the voltage applied to the gate. This configuration is important for the SET's operation, allowing for the precise control and measurement of electron tunneling events, which are sensitive to the charge environment near the SET.

In contrast, the SEB's single barrier design offers benefits in terms of i.a. device compactness, integration potential, scalability, etc.

Optionally, the operation of the SEB detector requires cryogenic temperatures below 4 Kelvin. In some examples, the SEB detector operates at or below 1 Kelvin for enhanced performance.

Optionally, the conductive island of the SEB detector has a size smaller than 100 nanometers. In some examples, the size of the conductive island is in the range of 40-50 nanometers. Other sizes are also possible.

Optionally, the material composition of the SEB detector can be either normal (non-superconducting) or superconducting. In some examples, the use of superconducting materials in the SEB detector introduces additional physical phenomena that enhance sensitivity. However, this may also complicate the interpretation of readout data.

Optionally, the quantum electronic device is adaptable for use not only in spin qubit readout applications but also in charge qubit systems.

In some examples, a calibration process may be carried out, involving the adjustment of operational parameters to accommodate the specific material composition and/or size specifications of the SEB detector and/or other associated components for optimal functionality at the operational conditions (e.g. cryogenic temperatures).

Optionally, the SEB detector and associated components are constructed from doped silicon, providing enhanced conditions for quantum tunneling and charge detection.

Optionally, the lead/electrode of the SEB detector comprises a composite of metals. In some examples, at least a portion of the metals exhibit superconducting properties, to facilitate improved conductive capabilities and superconducting phenomena under specific conditions.

Optionally; the quantum tunnel barrier of the SEB detector is made of dielectric material with a thickness in the range of two to three nanometers.

Optionally, the thickness of the quantum tunnel barrier is precisely chosen to achieve optimal performance in electron tunneling, indicative of quantum state variations.

Optionally, the SEB detector and its quantum tunnel barrier are calibrated through a process involving theoretical modeling and empirical validation to match the capacitance of the SEB and tunnel barrier with a corresponding inductor, forming a resonant LC circuit.

Optionally, the calibration process is designed to enhance the detection mechanism's sensitivity and accuracy for qubit state readout.

Optionally, the circuitry connected to the SEB detector includes cryogenic amplifiers and circulators as part of an array of RF electronics.

Optionally, the SEB detector requires only a single wire for connection to the operational circuitry. This allows a simple integration into quantum processing systems with a compact and efficient design.

According to an aspect, the invention provides for a method for determining a property of a qubit associated with a semiconductor quantum dot in a quantum electronic device, the method comprising: arranging at least one charge detector in the vicinity of the semiconductor quantum dot, wherein the charge detector comprises a single electron box, SEB, detector, wherein the SEB detector includes a conductive island that is separated from an electrode by a quantum tunnel barrier, wherein the quantum tunnel barrier is configured to facilitate electron tunneling, which is indicative of quantum state variations of the qubit, utilizing the electron tunneling through the quantum tunnel barrier to infer a state of the qubit associated with the quantum dot; connecting the electrode to circuitry configured to facilitate readout of the inferred qubit state.

Advantageously, a single electron box (SEB) can be used as a charge detector for single-shot readout of spin-based semiconductor qubits. Single electron box is a small conductive island isolated from a terminal by a tunnel junction. It can provide for similar sensitivity as a single electron transistor (SET) but in a compact form-factor. It can be fabricated in the vicinity of the qubit without taking a lot of footprint or ultimately even be built-in to a plunger gate of a quantum dot hosting a qubit. Such detectors allow single-shot spin state readout without compromising quantum circuit complexity.

Single electron box is a small conductive island isolated from a terminal by a tunnel junction. It can be connected to a radio-frequency LC circuit at matching conditions electrons tunnel between the island and the terminal. Ability of electrons to tunnel in and out of the single electron box depends on the electrostatic environment around it. This allows detect variation in the electric field around the island by change in the parameters of reflected signal. Such variation happens during spin-to-charge conversion during qubits readout. It makes it possible to use single-electron-box as a charge detector for spin-qubits readout.

Single electron box has only one electrode thus doesn't need much space. At the same time, being well coupled to the terminal it provides better sensitivity than a regular gate reflectometry technique. As this device has less terminals than RF single electron transistor, it may be harder to tune this device into operational window compared to solutions involving the use of SET.

In some examples, a configuration is provided with a single electron box integrated in a quantum dot plunger gate allowing simultaneous qubit accumulation and readout. For example, the SEB detector may be arranged as a termination of a quantum dot plunger gate.

Optionally, the SEB detector and the circuitry are configured to support RF dispersive readout through the use of an LC resonator circuit tuned to the resonant frequency of the system, facilitating electron tunneling detection through phase alterations in the circuit's oscillations.

Optionally, a readout mechanism that employs radio frequency (RF) reflectometry is applied directly to a plunger gate to detect quantum state changes within a qubit through observed variations in the phase of an RF signal.

According to an aspect, the invention provides for a quantum processing system comprising a quantum electronic device according to the disclosure.

In some examples, the SEB sector is used for performing a single-shot readout of spin-based semiconductor qubits. The SEB may be employed as a charge detector to detect charge states resulting from spin-to-charge conversion. The SEB may have a conductive island isolated from a terminal by a tunnel junction. The SEB may be connected/connectable to a radio-frequency LC circuit, wherein electron tunneling between the island and the terminal is modulated based on the electrostatic environment around the SEB.

In some examples, a plurality of spin-based semiconductor qubits and corresponding SEBs configured for single-shot spin state readout are arranged, wherein each SEB is fabricated in the vicinity of a respective qubit.

In some examples, the SEBs are integrated into plunger gates of quantum dots hosting the qubits, allowing simultaneous qubit accumulation and readout. However, it is also possible that the SEBs are distinct components arranged at a distance of the plunger gates.

The system may be implemented in a variety of configurations. For instance, the quantum processing system may include a quantum electronic device configured as a quantum bit processor, utilizing an array of quantum dots to perform quantum logic operations. Alternatively, the system may be embodied as a quantum simulator, wherein the quantum electronic device is employed to model complex quantum systems. Another exemplary implementation involves a quantum cryptographic device, leveraging the principles of quantum mechanics to facilitate secure communication. In this case, the quantum electronic device may be be integral in generating and manipulating quantum keys for encryption and decryption purposes.

Furthermore, in some examples, the quantum processing system may be adapted to serve as a quantum sensor, with the quantum electronic device functioning to detect and measure quantum effects at high precision, which can be beneficial in fields such as metrology and medical imaging.

Each of these implementations may utilize a quantum electronic device with single or multiple SEB detectors, operating in either a normal or a superconducting state to optimize performance based on the operational requirements. The system may further be integrated with classical electronic components to form a hybrid processing unit, thus expanding the practical applications of quantum computing technologies in various domains.

According to an aspect, the invention provides for a charge detector for use in a quantum electronic device, the charge detector comprising: a conductive island configured to participate in electron tunneling events, wherein the conductive island is operative to detect changes in electrical charge indicative of quantum state variations within a semiconductor quantum dot; a quantum tunnel barrier disposed adjacent to the conductive island, wherein the quantum tunnel barrier is structured to enable selective electron tunneling between the conductive island and an electrode, thereby facilitating detection of quantum state variations based on the tunneling events; and an electrode positioned in proximity to the conductive island and separated therefrom by the quantum tunnel barrier, wherein the electrode is adapted for connection to circuitry designed to interpret the detected changes in electrical charge as information regarding the state of a qubit associated with the semiconductor quantum dot; wherein the charge detector is characterized by its capability to operate as a single electron box (SEB) detector, utilizing the quantum tunnel barrier for detecting qubit's quantum state variations. This enables accurate readout of qubit states through the associated circuitry.

According to an aspect, the invention provides for a quantum electronic apparatus, comprising: at least one charge detector configured for determining a characteristic of a semiconductor quantum dot, said charge detector situated at or proximate to the semiconductor quantum dot, wherein the charge detector includes a single electron box (SEB) detector, which includes: a conductive island, which is delineated from an electrode by a quantum tunnel barrier, said quantum tunnel barrier tailored to enable electron tunneling reflective of quantum state alterations, wherein such tunneling is employed to ascertain the state of a qubit correlated with the quantum dot; and an electrode, which is connected to circuitry configured to enable the readout of the qubit state associated with the quantum dot.

It will be appreciated that a single electron box may be understood as a quantum electronic device that demonstrates the principles of single-electron tunneling and charge quantization. It may have a small conductive (e.g. metallic) island that is connected to an external circuit by a tunnel junction. The tunnel junction allows electrons to "tunnel" through an insulating barrier due to quantum mechanical effects.

It will be appreciated that any of the aspects, features and options described in view of the device apply equally to the method and the described system. It will also be clear that any one or more of the above aspects, features and options can be combined.

### BRIEF DESCRIPTION OF THE DRAWING

The invention will further be elucidated on the basis of exemplary embodiments which are represented in a drawing. The exemplary embodiments are given by way of non-limitative illustration. It is noted that the figures are only schematic representations of embodiments of the invention that are given by way of non-limiting example.

In the drawing:
Fig. 1 shows a schematic diagram of an embodiment of a quantum electronic device;
Fig. 2 shows a schematic diagram of an embodiment of a quantum electronic device;
Fig. 3 shows a schematic diagram of an embodiment of a quantum electronic device;
Fig. 4 shows a schematic diagram of an embodiment of a quantum electronic device; and
Fig. 5 shows a schematic diagram of a method.

### DETAILED DESCRIPTION

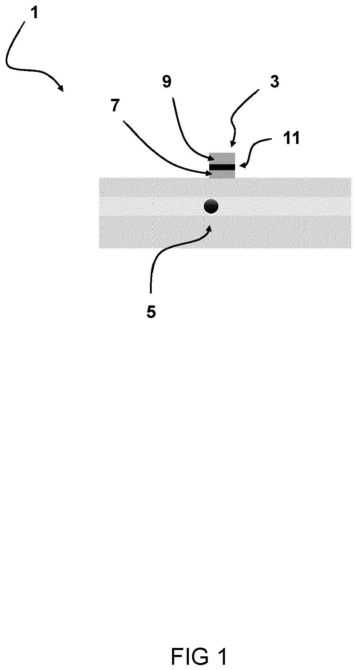

Fig. 1 shows a schematic diagram of a cross-sectional side view of an embodiment of a quantum electronic device 1 comprising at least one charge detector 3 configured to determine a property of a semiconductor quantum dot 5, the charge detector 3 being arranged at or in vicinity of the semiconductor quantum dot 5. The charge detector 3 is a single electron box, SEB, detector 3 including a conductive island 7 separated from an electrode 9 by means of a quantum tunnel barrier 11. The quantum tunnel barrier 11 is configured to facilitate electron tunneling indicative of quantum state variations. The tunneling is used to infer a state of a qubit associated with the quantum dot 5. The electrode 3 is connectable to a circuitry configured to enable readout of the state of the qubit associated with the quantum dot 5.

In some examples, the SEB detector 3 is connected to a radio-frequency, RF, circuitry. The RF circuitry may for instance include an LC resonating circuit matched to the impedance of the SEB detector 3 for qubit state detection. The RF circuitry may be configured to facilitate dispersive readout based on RF reflectometry. In some examples, the RF circuitry is configured to detect spin-to-charge conversion events by monitoring changes in reflected signal parameters.

In the exemplary embodiment depicted, a singular SEB detector 3 is illustrated; however, it should be recognized that the scope of the present invention is not limited to a single detector configuration. The quantum electronic device 1 may be configured with a plurality of SEB detectors, for example each detector being strategically arranged either proximate to or at disparate quantum dots within the device architecture.

The incorporation of multiple SEB detectors facilitates simultaneous or sequential interrogation of various quantum dots 5, thereby enabling a multiplexed approach to quantum state detection. This configuration enhances the device's capability to perform complex quantum operations, increases the throughput of quantum information processing, and allows for redundancy in measurements, improving the overall fidelity and robustness of the system.

The arrangement of multiple detectors can be tailored according to specific operational requirements, wherein detectors can be placed in close proximity to allow for interaction between quantum dots, or they can be distributed to interact with isolated quantum dots for independent operation. Such an arrangement is advantageous for scaling up the quantum electronic device 1 to accommodate a larger qubit array, thereby paving the way for more complex quantum computing applications.

In some examples, the SEB operates at cryogenic temperatures below 4 Kelvin to ensure operational stability and sensitivity. For example, the operational temperature may be at or below 1 Kelvin for enhanced electron tunneling conditions. However, other temperature conditions are also possible.

In some examples, the quantum detector device is adapted for use in detecting quantum states in charge qubits, wherein the SEB detects the position of a single electron. The detection of charge qubit states may employ spin-to-charge conversion to infer the electron's position from observable signal variations. The conductive island of the SEB may be dimensioned smaller than 100 nanometers in order to ensure effective quantum state sensitivity. In some examples, exemplary dimensions of the conductive island are in the range of 20-70 nanometers, for example 40-50 nanometers.

In some examples, a calibration mechanism is provided for the RF circuitry based on modeling and/or experimental validation to match the inductor to the SEB's inductance for precise quantum state detection.

In some examples, the conductive island of the SEB detector 3 is fabricated from silicon or a doped semiconductor material. Other materials may also be used.

In some examples, the tunnel barrier has a thickness in the range of nanometers to facilitate quantum tunneling of electrons. For example, the tunnel barrier thickness may be less than 3 nanometers to optimize electron tunneling efficiency. Various dimensions are envisaged.

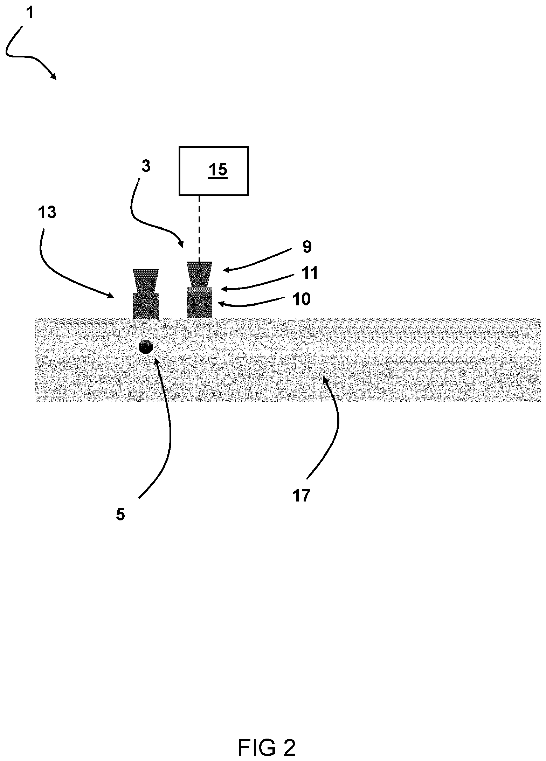

Fig. 2 shows a schematic diagram of a cross sectional side view of an embodiment of a quantum electronic device 1. In this embodiment, the quantum electronic device 1 comprises a plunger gate 13 for controlling one or more characteristics of the quantum dot 5. The SEB detector 3 has a single electron box 10. A quantum tunnel barrier 11 is arranged between said single electron box 10 and a lead 9 (cf. electrode) of the SEB detector 3. The lead 9 may be connected to a readout unit 15. In some examples, the readout unit 15 may be an electronic unit. For example, the readout unit 15 may be a RF dispersive readout unit. An on-chip resonator may be employed. However, other arrangements and configurations are also envisaged.

In this example, the SEB detector 3 is distinctly positioned apart from, yet in immediate vicinity to, the plunger gate structure 13.

It will be appreciated that the single electron box (SEB) 10, the quantum tunnel barrier 11, and the lead 9 of the SEB detector 3 may be operated in a "normal" or superconducting state. This operational flexibility enhances the functionality and application range of the quantum electronic device 1. When functioning in a "normal state", the conductive elements such as the SEB box 10, the quantum tunnel barrier 11, and the lead 9 exhibit standard resistive behavior characterized by a non-zero resistance at low temperatures. This state is beneficial for applications where traditional charge dynamics and dissipation are required. Conversely, operation in a superconducting state implies that the aforementioned elements transition into a phase characterized by zero electrical resistance and the expulsion of magnetic fields (Meissner effect) when cooled below a critical temperature specific to the material. The superconducting state is advantageous for quantum computing applications, where minimal energy loss and magnetic flux trapping are critical.

It is to be appreciated that the superconducting state enables quantum coherence to be maintained over longer timescales, which can be important for the operation of quantum bits (qubits) and the precise manipulation of single electrons within the quantum dot 5. Moreover, the integration of a superconducting SEB detector 3 with a RF dispersive readout unit 15 can significantly enhance the sensitivity and speed of the quantum state measurement process due to the reduced electronic noise.

Such an arrangement can be realized by employing materials known for their superconducting properties, such as aluminum or niobium, and designing the device such that it can be maintained at cryogenic temperatures conducive to superconductivity.

The device's ability to operate in either state without the need for structural modifications provides a versatile platform for various quantum electronic applications.

Furthermore, in the exemplified embodiment, the quantum electronic device 1 includes a substrate 17, which may be constituted with or without a Quantum Well (QW). The inclusion of a Quantum Well within the substrate 17 serves to create a potential well where electrons or holes can be confined in the dimension perpendicular to the substrate surface, leading to quantized energy levels that are advantageous for enhancing electronic and/or optical properties.

The provision for the substrate 17 to either include or exclude a Quantum Well enables the device to be tailored for specific quantum electronic functionalities. A substrate with a Quantum Well is particularly beneficial for applications requiring discrete energy states, which are important for the operation of quantum dots and for the creation of quantized conductance channels. This is important for the deterministic control of electron waves and can lead to the development of high-performance quantum electronic devices with improved control over electron transport.

On the other hand, a substrate without a Quantum Well is also contemplated to address applications where such quantization is not necessary, thereby providing a versatile platform that can be optimized for a wide range of operational requirements.

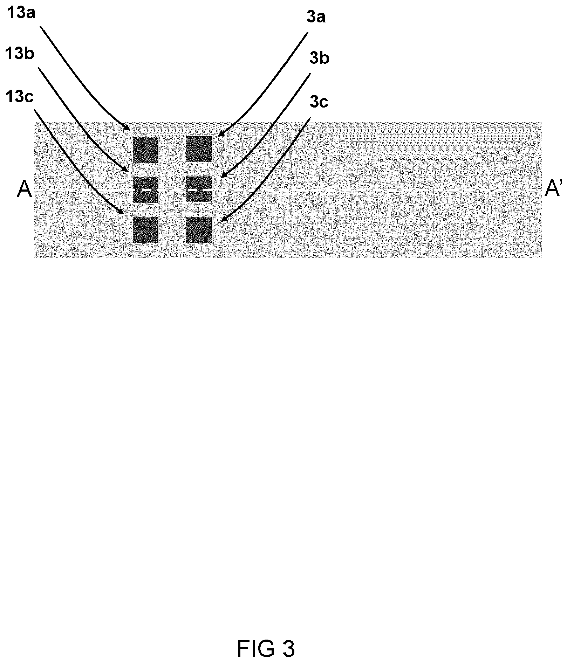

Fig. 3 shows a schematic diagram of a top view of an embodiment of a quantum electronic device 1. The cross sectional line A-A' corresponds with the cross section shown in fig. 2. In this example, the quantum electronic device 1 includes three SEB detectors 3a, 3b, 3c arranged next to three plunger gates 13a, 13b, 13c. However, a different number may also be employed. Furthermore, various other arrangements and configurations may be employed.

Although not the case in the shown example of fig. 3, in some embodiments, the SEB can be integrated with or embedded in of a quantum dot's plunger gate, for example at an end portion of said plunger gate. This configuration not only allows for the efficient readout of the qubit's state but also facilitates the qubit's accumulation and control within the quantum dot. This dual functionality, combined with the SEB's compact size, offers a significant advantage in designing more complex and densely packed quantum circuits, enhancing the scalability and performance of quantum processors.

It will be appreciated that integrating the SEB directly into the plunger gate of a quantum dot may be understood as embedding this charge detection mechanism within the gate structure itself. This integration aims to achieve a compact design that allows for the direct and efficient readout of the qubit's state without requiring additional space for separate charge detectors. Since the SEB can detect changes in the electrostatic environment due to its sensitive tunnel junction, placing it in close proximity to, or as part of, the plunger gate enables it to directly monitor the state of the quantum dot.

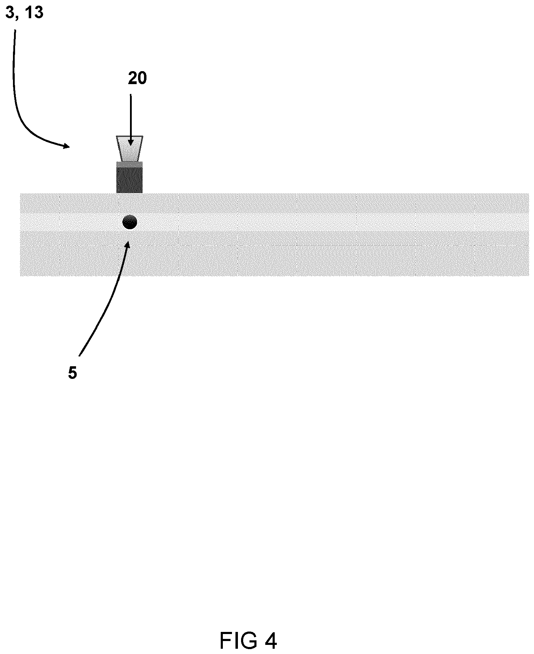

Fig. 4 shows a schematic diagram of an embodiment of a quantum electronic device 1. In this example, the SEB detector 3 is integrated in a structure of the plunger gate 13. The SEB detector can be integrated as a termination of the plunger gate 13. For example, the plunger gate 13 and the SEB detector 3 may be arranged such that adjustments to a plunger gate potential influence the electron tunneling through the quantum tunnel barrier 11. The (readout) circuitry may be connected to the plunger gate 13. In such exemplary embodiments, a SEB gate-detector 20 may be formed at the plunger gate 13.

The integration of the SEB detector 3 with the plunger gate 13 can substantially reduce the time lag between qubit state manipulation and its detection, which can be important for fast-paced quantum computing operations.

The proximity and direct connection between the control and detection components enhance the device's sensitivity to changes in the quantum dot's electrostatic environment, allowing for the detection of subtle quantum state variations. By combining two critical functions within a single structural element, the device architecture is simplified, potentially reducing the complexity and cost of fabrication of the quantum electronic device 1.

By coordinating the manipulation of the quantum dot's potential with the detection of electron tunneling events, the device ensures that the readout of qubit states is both accurate and timely, reducing latency and increasing the speed of quantum computations. Ultimately, the direct influence of plunger gate adjustments on electron tunneling enhances the overall performance of quantum computing operations. This improvement is manifested in more accurate and efficient quantum algorithms, with a reduced error rate and enhanced capability for complex quantum computations.

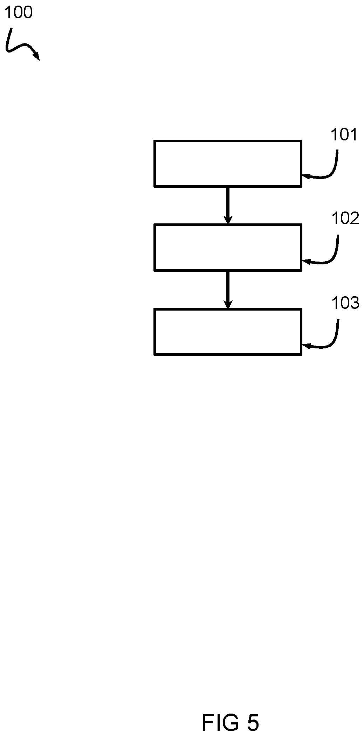

Fig. 5 shows a schematic diagram of a method 100 for determining a property of a qubit associated with a semiconductor quantum dot in a quantum electronic device. In a first step 101, at least one charge detector is arranged in the vicinity of the semiconductor quantum dot, wherein the charge detector comprises a single electron box, SEB, detector, wherein the SEB detector includes a conductive island that is separated from an electrode by a quantum tunnel barrier, wherein the quantum tunnel barrier is configured to facilitate electron tunneling, which is indicative of quantum state variations of the qubit. In a second step 102, the electron tunneling through the quantum tunnel barrier is utilized to infer a state of the qubit associated with the quantum dot. In a third step 103, the electrode is connected to (readout) circuitry configured to facilitate readout of the inferred qubit state.

A single electron box (SEB) is used instead of for example the traditional RF SET for the readout process. The SEB is a more compact and efficient, allowing for more complex and densely packed qubit arrangements in a quantum computer/processor. This setup could lead to more powerful quantum computers by enabling more qubits to interact closely and complexly.

Unlike the RF SET, which needs three connections (like needing three wires to plug into something), the SEB only needs one wire, making it much simpler to integrate into the quantum computing setup. Its operation is based on detecting changes in the electric field around it when electrons move in and out through the quantum tunnel barrier, which indicates the state of the qubit. This method can provide for similar sensitivity as solutions with RF SET, but being much more space-efficient.

This compactness allows for the SEB to be placed very close to a qubit, significantly reducing the spatial footprint required for each charge detector in a quantum computing setup. It even presents the possibility of integrating the SEB directly into the plunger gate of a quantum dot, which is a structure used to confine and control electrons (and thus qubits) within a semiconductor. This integration may facilitate both the manipulation (accumulation) of qubits and their readout without necessitating additional space or complex circuit designs.

The operation of the SEB can be tied to a radio-frequency (RF) LC circuit, which may be an electrical circuit comprising an inductor (L) and a capacitor (C) that can resonate at specific frequencies. When this circuit is tuned to the right conditions, electrons can tunnel between the SEB's island and the terminal. The rate and ability of electrons to tunnel in this manner depend heavily on the electrostatic environment surrounding the SEB, which changes when a qubit's spin state changes (the spin-to-charge conversion process during qubit readout).

The method facilitates the creation of more intricate quantum circuit designs utilizing spin qubits, which are a fundamental component of quantum information processing. Spin qubits, characterized by their long coherence times and the potential for manipulation at the single-electron level, are central to the advancement of quantum computing. The configuration of the quantum electronic device, which includes the ability integrate multiple SEB detectors, allows for the design of complex quantum circuits that can address more challenging computational problems.

For example, the increased complexity of circuit design enabled by this invention lays the groundwork for the implementation of quantum error correction protocols. Quantum error correction is vital for maintaining the integrity of quantum information and for the realization of fault-tolerant quantum computing. By facilitating more elaborate circuit topologies, the invention allows for the incorporation of error-correcting codes that can detect and correct for quantum errors during computation. This significantly increases the potential for quantum processors to execute prolonged and more complex algorithms.

It will be appreciated that the method may include computer implemented steps. Embodiments may comprise computer apparatus, wherein processes performed in computer apparatus. The invention also extends to computer programs, particularly computer programs on or in a carrier, adapted for putting the invention into practice. The program may be in the form of source or object code or in any other form suitable for use in the implementation of the processes according to the invention. The carrier may be any entity or device capable of carrying the program. For example, the carrier may comprise a storage medium, such as a ROM, for example a semiconductor ROM or hard disk. Further, the carrier may be a transmissible carrier such as an electrical or optical signal which may be conveyed via electrical or optical cable or by radio or other means, e.g. via the internet or cloud.

Some embodiments may be implemented, for example, using a machine or tangible computer-readable medium or article which may store an instruction or a set of instructions that, if executed by a machine, may cause the machine to perform a method and/or operations in accordance with the embodiments.

Various embodiments may be implemented using hardware elements, software elements, or a combination of both. Examples of hardware elements may include processors, microprocessors, circuits, application specific integrated circuits (ASIC), programmable logic devices (PLD), digital signal processors (DSP), field programmable gate array (FPGA), logic gates, registers, semiconductor device, microchips, chip sets, et cetera. Examples of software may include software components, programs, applications, computer programs, application programs, system programs, machine programs, operating system software, mobile apps, middleware, firmware, software modules, routines, subroutines, functions, computer implemented methods, procedures, software interfaces, application program interfaces (API), methods, instruction sets, computing code, computer code, et cetera.

Herein, the invention is described with reference to specific examples of embodiments of the invention. It will, however, be evident that various modifications, variations, alternatives and changes may be made therein, without departing from the essence of the invention. For the purpose of clarity and a concise description features are described herein as part of the same or separate embodiments, however, alternative embodiments having combinations of all or some of the features described in these separate embodiments are also envisaged and understood to fall within the framework of the invention as outlined by the claims. The specifications, figures and examples are, accordingly, to be regarded in an illustrative sense rather than in a restrictive sense. The invention is intended to embrace all alternatives, modifications and variations which fall within the scope of the appended claims. Further, many of the elements that are described are functional entities that may be implemented as discrete or distributed components or in conjunction with other components, in any suitable combination and location.

In the claims, any reference signs placed between parentheses shall not be construed as limiting the claim. The word 'comprising' does not exclude the presence of other features or steps than those listed in a claim. Furthermore, the words 'a' and 'an' shall not be construed as limited to 'only one', but instead are used to mean 'at least one', and do not exclude a plurality. The term "and/or" includes any and all combinations of one or more of the associated listed items. The mere fact that certain measures are recited in mutually different claims does not indicate that a combination of these measures cannot be used to an advantage.

## Claims

1. A quantum electronic device comprising at least one charge detector configured to determine a property of a semiconductor quantum dot, the charge detector being arranged at or in vicinity of the semiconductor quantum dot, wherein the charge detector is a single electron box, SEB, detector including a conductive island separated from an electrode by means of a quantum tunnel barrier, wherein the quantum tunnel barrier is configured to facilitate electron tunneling indicative of quantum state variations, wherein the tunneling is used to infer a state of a qubit associated with the quantum dot, wherein the electrode is connected to a circuitry configured to enable readout of the state of the qubit associated with the quantum dot.

2. The quantum electronic device of claim 1, wherein the SEB detector is connected to a radio-frequency, RF, circuitry.

3. The quantum electronic device of claim 2, wherein the RF circuitry includes an LC resonating circuit matched to the impedance of the SEB detector for qubit state detection.

4. The quantum electronic device of claim 2 or 3, wherein the RF circuitry is configured to facilitate dispersive readout based on RF reflectometry, wherein the RF circuitry is configured to detect spin-to-charge conversion events by monitoring changes in reflected signal parameters.

5. The quantum electronic device of any one of the preceding claims, wherein the device comprises a plunger gate for controlling one or more characteristics of the quantum dot.

6. The quantum electronic device of claim 5, wherein the SEB detector is integrated in a structure of the plunger gate.

7. The quantum electronic device of claim 5 or 6, wherein the SEB detector is integrated as a termination of the plunger gate.

8. The quantum electronic device of claim 5, 6 or 7, wherein the plunger gate and the SEB detector are arranged such that adjustments to a plunger gate potential influence the electron tunneling through the quantum tunnel barrier.

9. The quantum electronic device of any one of the preceding claims 5-8, wherein the circuitry is connected to the plunger gate.

10. The quantum electronic device of claim 5, wherein the SEB detector is distinctly positioned apart from, yet in immediate vicinity to, the plunger gate structure.

11. The quantum electronic device of any one of the preceding claims, wherein the SEB detector is configured to detect charge states associated with spin-based semiconductor qubits through spin-to-charge conversion.

12. The quantum electronic device of any one of the preceding claims 3-11, wherein changes in the parameters of a reflected signal from the RF LC circuit indicate variations in the electric field around the conductive island of the SEB detector, corresponding to spin-to-charge conversion events during qubit readout.

13. The quantum electronic device of any one of the preceding claims, wherein the SEB detector includes a single quantum tunnel barrier.

14. A method for determining a property of a qubit associated with a semiconductor quantum dot in a quantum electronic device, the method comprising:
arranging at least one charge detector in the vicinity of the semiconductor quantum dot, wherein the charge detector comprises a single electron box, SEB, detector, wherein the SEB detector includes a conductive island that is separated from an electrode by a quantum tunnel barrier, wherein the quantum tunnel barrier is configured to facilitate electron tunneling, which is indicative of quantum state variations of the qubit,
utilizing the electron tunneling through the quantum tunnel barrier to infer a state of the qubit associated with the quantum dot;
connecting the electrode to circuitry configured to facilitate readout of the inferred qubit state.

15. A quantum processing system comprising a quantum electronic device according to any one of the preceding claims.
